(19) Europäisches Patentamt
European Patent Office
Office européen des brevets

(11) Publication number: 0 032 421
B2

(12) NEW EUROPEAN PATENT SPECIFICATION

(45) Date of publication of the new patent specification: 22.04.87

(51) Int. Cl.[4]: C 04 B 14/38, C 04 B 16/06, C 04 B 30/02, E 04 C 5/01

(21) Application number: 81300044.5

(22) Date of filing: 07.01.81

(54) **Fiber-reinforced concrete.**

(30) Priority: 11.01.80 JP 2280/80

(43) Date of publication of application: 22.07.81 Bulletin 81/29

(45) Publication of the grant of the patent: 02.11.83 Bulletin 83/44

(45) Mention of the opposition decision: 22.04.87 Bulletin 87/17

(84) Designated Contracting States: DE FR GB

(56) References cited:
EP-A-0 006 318
BE-A- 877 534
CH-A- 568 252
DE-A-2 132 794
DE-A-2 816 457
DE-A-2 819 794
DE-A-3 002 484
DE-B-1 239 255
FR-A-2 296 601
GB-A-1 418 091

**The file contains technical information submitted after the application was filed and not included in this specification**

(73) Proprietor: MITSUI PETROCHEMICAL INDUSTRIES, LTD.
2-5, Kasumigaseki 3-chome Chiyoda-ku
Tokyo 100 (JP)

(72) Inventor: Kobayashi, Kazusuke
571, Unomori, Sagamihara-shi
Kanagawa (JP)
Inventor: Cho, Ryokche
102-282 Tokiwadai, Hodogaya-ku
Yokohama-shi, Kanagawa (JP)

(74) Representative: Denmark, James
c/o Bailey Walsh & Co. 5 York Place
Leeds LS1 2SD Yorkshire (GB)

(56) References cited:
GB-A-2 025 841
JP-A-45 030 650
JP-A-49 037 407
JP-A-49 104 918
JP-A-52 095 025

COMPOSITES, Vol. 10, No. 1, January 1979 A.J. MAJUMDAR et al. "Fibre Cement Composites: Research at BRE" pages 17 to 27

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 032 421 B2

**Description**

This invention relates to composite materials (referred to herein as "concretes") obtained by uniformly dispersing short fibres in mortars or concretes.

It is known to incorporate or disperse in concretes a reinforcing material such as steel fibers in order to improve the tensile and flexural strength of the concrete. Such a technique has been already disclosed in United States Patent US—A—3,953,953 and the resulting reinforced concretes have been used as paving materials and linings for tunnels because of their excellent characteristics. These fiber-reinforced concretes are incorporated to ensure higher resistance to cracking and higher maximum loads as compared with ordinary concretes but have a drawback that high toughness cannot be expected since the impartment of toughness is dependent on whether the short fiber is easy to be pulled out from a concrete matrix.

It is also known that by incorporating reinforcing material of a synthetic plastic fiber in concrete, the concrete can withstand a fairly great degree of deformation and is remarkably improved in toughness as disclosed in British Patent GB—A—1,305,206, but such concrete has a drawback that the crack resistance is small, i.e. load carrying capacity is small.

The invention in its various aspects has a number of objectives including the following:—

the object to provide a fiber-reinforced concrete which overcomes the disadvantages of prior art counterparts;

the object to provide a fiber-reinforced concrete having predetermined amounts of two kinds of short fibers incorporated or dispersed in concrete whereby the disadvantages of concretes where such short fibers are singly incorporated can be eliminated;

the object to provide a fiber-reinforced concrete which has a remarkably improved crack resistance and increased toughness; and

the object to provide a reinforcing material composed of two different kinds of short fibers.

According to the invention there is provided a fiber-reinforced concrete comprising a concrete matrix containing 1—6% by volume of a mixture of a short steel fiber (A) with a length of 20—60 mm and a thickness of 0.2—1 mm having a Young's modulus higher than that of the concrete and short polyethylene fiber (B) with a length of 5—100 mm and a thickness of 1000—15000 denier having a Young's modulus lower than the concrete and being an elongated extruded fiber of a cross section having projections distributed on the surface of the fibers at a frequency of 5 to 25 per 10 cm length with a height of 0.1 mm or more and diameter of 0.5—2 mm so that it has good adhesiveness to the concrete, the both fibers having been dispersed in said concrete matrix in a mixing volume ratio B/A ranging from 0.5 to 6 and the reinforcing amount of the short steel fiber (A) ranging from 0.5 to 3% by volume and that of the polyethylene fiber (B) ranging from 0.5 to 5% by volume.

By the invention, the reinforced concrete shows an improved load bearing capacity, (which will be lowered after generation of cracks in the case of a concrete in which the short fiber (B) alone is incorporated,) and by the addition of the short fiber (A) shows a crack-resistant tendency. Rapid lowering of the load bearing capacity of a concrete which occurs when the short fiber (A) alone is used can be avoided by the use of the short fiber (B) serving as a viscoelastic material.

Embodiments of the invention will be explained with reference to the accompanying drawings wherein:—

Fig. 1 is a schematical view, in section, of a concrete according to an embodiment of the invention;

Figs. 2a and 2b are, respectively, schematical enlarged and perspective views of short fiber (A) and short fiber (B);

Fig. 3 shows flexural load (t) -v- deflection (mm) graphs for a steel fiber-reinforced concrete (for comparison) and for a steel and polymer fibers-reinforced concrete according to the invention for different loading speeds;

Fig. 4 shows flexural load (t) -v- deflection length (mm) graphs for polymer fiber-reinforced concretes at a constant loading speed;

Fig. 5 shows flexural load (t) -v- deflection length (mm) graphs for concretes according to the invention with relation to flexural loads;

Figs. 6 and 7 show flexural load (t) -v- deflection (mm) graphs for concretes according to the invention for different loading speeds; and

Fig. 8 shows flexural load (t) -v- deflection (mm) for a reinforced concrete according to the invention, when the load is applied by simple and repeated loading procedures.

In general, the Young's modulus of composite materials varies depending on the composition and the method of manufacturing the composition and Young's modulus of concrete is in the range of about 2,000—4,000 kg/mm$^2$ (measured under ASTM C469—65).

The short fiber (A) has a Young's modulus higher than that of the concrete, preferably in the range of 4,500 to 30,000 kg/mm$^2$. The short steel fibers may be a stainless steel fiber, a galvanized steel fiber, etc). Steel fibers have a Young's modulus ranging from 19,000 to 21,000 kg/mm$^2$ (measured under ASTM E111—61). Particularly suitable steel fibres are disclosed in United States Patent US—A—3,953,953. The fibers may be of circular, square part circular or part square in section, and of a rod or wire or a twisted rod as a whole, with or without being processed at the ends thereof, and may be produced by the method of shearing or cutting steel plate, cutting steel wire or melt extraction of steel. They may generally have a thickness or diameter of 0.2—1 mm and a length of 20—60 mm.

The short polyethylene fiber (B) is extruded and has a small Young's modulus as mentioned above. The Young's modulus of the fibre B is in the range of 100—1,000 kg/mm$^2$ (measured under ASTM D3379—75).

In order to attain good adhesion to the concrete, the surfaces of the fibers (B) are preferably irregular rather than smooth. Conveniently, the fibers useful in the present invention are those including branches, sawtooth, knapped or nobbly fibers or fibers which are formed with warts or saw tooth-like projections or indentations along the axis of fiber. These projections may be arranged regularly or irregularly. High adhesion to concrete is ensured when the projections are formed discontinuously rather than continuously. The fibers of such a configuration as mentioned above are described, for example in British Patents GB—A—1,010,143 and GB—A—1,305,206 and United States Patents US—A—3,127,915 and US—A—3,567,569.

The polyethylene short fiber has projections or is made irregular on the surface thereof so as to enhance the adhesiveness to concrete, and has a length of 5—100 mm, preferably 10—80 mm, most preferably 20—60 mm, and a thickness of 1,000—15,000 denier, more perferably 3,000—12,000 denier. The number of projections is 5—25 per the length of 10 cm, preferably 7—20, more preferably 10—16, the height of each projection is 0.1 mm or more, and the diameter of the fiber is 0.5—2 mm.

These parameters are determined depending on the uniform dispersability of the fibers into concrete and the physical properties of the reinforced concrete desired.

For instance, a polyethylene fiber having such a configuration can be obtained by melt blending a high density polyethylene with a melt index of 0.01—1.0 g/10 min. (as measured on the basis of ASTM D 1238—65T at 190°C under the load of 2.16 kg) with 10—80 wt% of a high density polyethylene with a melt index below 0.01, extruding the blend into filaments under conditions where the melt fracture occurs, cooling and then stretching the filaments under orientation conditions lower than the melting point of the filaments and cutting them to a given length.

The polyethylene fiber of this type is described in United Kingdom Patent Application GB—A—2,025,841. The polyethylene fiber shows high mechanical strength when oriented in a lengthwise direction and has a Young's modulus of about 500 kg/mm$^2$.

The short fibers (A) and (B), are used in combination and the mixing ratios in concrete, i.e. the total amount of the short fibers (A) and (B), the amounts of the respective fibers and the mixing ratios of the fibers (A) and (B), are important in the practice of the invention.

The total amount of the short fibers (A) and (B) is in the range of 1—6% by total volume of a concrete used.

Less amounts than 1 vol% are disadvantageous since a significant reinforcing effect does not develop, while larger amounts than 6 vol% are disadvantageous in that the fibers tend to be tangled and cannot be uniformly dispersed in a concrete matrix easily, with the result that the concrete is lowered in strength and also in working property to a considerable extent, making the use of such a concrete difficult. The mixing ratio is expressed by volume% in 1 mm$^3$ of a concrete composition composed of cement, water, fibers, fine or coarse aggregates such as sand, broken stone and gravel, and the like. If necessary, other additives or improvers may be added to the composition.

The amounts of the respective fibers (A) and (B) are as follows: An amount of the short fiber (A) is in the range of 0.5—3 vol%, preferably 1—2 vol%; and an amount of the short fiber (B) is in the range of 0.5—5 vol%, preferably 1—4 vol%, but in all the cases the mixing volume ratio of the two fibers B/A should be in the range of 0.5—6, and preferably 1—3, in order to achieve the good results at which the invention is aimed.

In practice, the short fiber (A) or steel and the short fiber (B) of polyethylene are mixed in a mixing volume ratio B/A of 0.5—6 and then packed such as in a bag or a box to give a packed reinforcing material.

The mixture of short fibers (A) and (B) of the present invention when embodied in a concrete matrix gives the concrete a high rigidity and fibers have less possibility of entanglement and thus have an improved dispersibility in the concrete matrix.

Because they have little tendency to become entangled, it is possible to thoroughly mix the fibers with concrete by means of an ordinary mixer with ease.

The fibers can be uniformly dispersed in the concrete without formation of fiber balls, thus giving a final product having a uniform distribution of the reinforcing material and no irregularity in strength. By virtue of the protrusions, the short fibers (B) have an improved anti-slipping out strength against the flexural stress exerted on the concrete material in which it is embedded. Accordingly, the flexural strength, impact strength and cracking strength of the concrete material are thereby increased, and the falling off of edges of the concrete material is thereby minimized.

The fiber-reinforced concrete of the present invention may be used for runways, beams for bridges, tunnels, flat plates, corrugated plates, pipes, construction blocks or the like.

In addition, the reinforced concrete in which the two fibers are incorporated according to the invention is superior in abrasion resistance to those where the fibers are dispersed singly, leading to an increasing durability, when applied as drainage canals of dam or sandbank fixing dams.

The present invention will be illustrated by way of the following example.

Example

In Fig. 1 there is shown a concrete of the invention in which short fibers (A) and (B) are dispersed.

The short fiber (A) used was a steel fiber Young's modulus: 200 × $10^4$ (kg/cm$^2$) (herein—abbreviated as SF) composed of sheared fibers having a size of 0.3 × 0.7 × 30 mm (Fig. 2a) and the short fiber (B) was a high density polyethylene fiber Young's modulus: 2.2 × $10^4$ (kg/cm$^2$) (herein abbreviated as PF) which has a specific density of 0.96 g/cm$^3$, a calculated diameter of 0.9 mm, a thickness of 5500 denier, and a length of 40 mm and which was oriented in a lengthwise direction and had branched or warts-like projections (1), (1) at given intervals in the fiber axial direction (Fig. 2b).

The concrete matrix Young's modulus: 35 × $10^4$ (kg/cm$^2$) has a water-to-cement ratio of 50:50 and the cement used was a high early strength Portland cement. The aggregate had a maximum size of 15 mm.

Samples were in the form of a beam having a size of 10 × 10 × 40 cm and a flexural test based on ASTM C78—75 was conducted by a two points loading on trisectional points (span, 30 cm).

The loading test was carried out using a material tester of the displacement control type (floor type TT tester by Instron Co. Ltd.). As for the loading speed, four cross head speeds (C.H.S.) of 0.5, 20, 100 and 200 mm/min. were used.

Of the test samples (1 to 4), are according to the invention and include combinations of steel and polyethylene fibers and the control samples (Nos. 5—9) include steel fiber or polyethylene fiber only, respectively.

The amounts of the respective fibers in the samples are shown in the following table.

| | Short fiber | SF (vol %) | PF (vol %) | | Short fiber | SF (vol %) | PF (vol %) |
|---|---|---|---|---|---|---|---|
| Inventive samples | No. 1 | 1.0 | 1.0 | Reference samples | No. 5 | 1.0 | |
| | No. 2 | 1.0 | 1.5 | | No. 6 | | 1.0 |
| | No. 3 | 1.0 | 2.0 | | No. 7 | | 1.5 |
| | No. 4 | 1.0 | 3.0 | | No. 8 | | 2.0 |
| | | | | | No. 9 | | 3.0 |

Fig. 3 shows an influence of the loading speed on the flexural load-deflection curves of concretes using steel and polyethylene fibers. As is apparent from the figure, with the PF-reinforced concrete (sample No. 9), there are tendencies that a higher loading speed results in larger crack-generating load and after a temporary lowering of the load bearing capacity, the load bearing capacity reaches a second peak, indicated by ⊙, at a relatively early stage of deformation and that a rate of lowering of the load bearing capacity becomes relatively large when the second peak is passed over.

Similar tendencies are observed in the case of the SF-reinforced concrete (sample No. 5), i.e. a larger loading speed results in a higher maximum strength and a higher rate of lowering of the load-flexural strength with increase in deformation.

Fig. 4 shows the influence of the amount of the polyethylene fiber on the flexural load-deflection characteristic of PF-reinforced concretes (sample Nos. 6—9) when the loading speed is held constant (20 mm/min.), from which it is found that a larger amount of PF leads to a smaller lowering of the load bearing capacity after the generation of cracks.

Fig. 5 shows flexural load-deflection curves of the sample Nos. 1—4 of the invention. In the figure, the broken line shows a flexural load-deflection curve of a reinforced concrete dispersed with SF alone (sample No. 5).

As is apparent from the figure, the flexural load-deflection characteristic of the samples of the invention is clearly different from that of the SF-reinforced concrete or PF-reinforced concrete (see Fig. 3).

That is, the flexural load-deflection behaviour of the inventive samples is as follows: (1) The maximum loads (loads at which a first leak occurs) are higher than that of the SF-reinforced concrete and degree of corresponding deflection is also larger; (2) The lowering of the load bearing capacity with increasing deformation is small; and (3) The samples with a greater mixing ratio of PF to SF show more remarkable tendencies of the above items 1 and 2. These results are considered due to a synergistic effect of SF and PF.

Especially, the sample No. 4 (SF: 1.0 vol%, PF: 3.0 vol%) shows an excellent toughness which is similar to the load-deformation characteristic at the yield point of a soft steel.

Figs. 6 and 7 show flexural load-deflection curves obtained by testing the sample Nos. 1—4 of the invention at four different loading speeds.

As is apparent from these figures, the influence of the loading speed on the flexural load-deflection behaviour involves the following tendencies: A higher loading speed results in (1) a larger degree of deflection at the maximum load in all the samples and also in a higher maximum load; (2) a higher amount of PF leads to a higher maximum load, and (3) the lowering of the load bearing capacity after the maximum load is small until the degree of deflection reaches a certain level, after which the lowering of the load bearing capacity is more considerable as compared with the case using a smaller loading speed.

It is believed that these results suggest that the mechanical characteristic of the samples of the invention is obtained from addition of flexural load-deflection characteristics obtained by changing the speed of a flexural test using concretes containing SF or PF.

Fig. 8 shows a flexural load-deflection curve (dot-and-dash line) and a repeated loading-deflection curve (solid line) obtained by carrying out a simple loading and a repeated loading on the reinforced concrete (sample No. 4) according to the invention. The broken line shows an envelope of maximum loads obtained by repetitions of loading.

As is clearly seen from the repeated loading-deflection curve of the figure, the load-deflection characteristic is almost the same as a simple flexural load-deflection curve through the residual amount of deflection increases due to an increasing width of crack. When the deflection length is 6 mm, the load bearing capacity is kept at about 75% of the maximum load in each sample, thus showing an excellent toughness.

It was confirmed that the yield strength was lost at the deflection length of about 10 mm in this example although this did depend upon the length of the fibers used.

In this example, the toughness of the fiber-reinforced concretes was quantitatively evaluated by calculating an area surrounded by the flexural load-deflection curve and the axis of abscissa (deflection length) in which a vertical line is drawn from the curve at a point, where the load bearing capacity corresponded to 80% of the maximum load, to the axis, and then determining the ratio of the area to an area of the SF-reinforced concrete (sample No. 5), with the results shown in the following table. The evaluation at the respective loading speeds was based on an area of the SF-reinforced concrete (sample No. 5) obtained at each loading speed.

| | | Short Fiber | | Loading Speed (mm/min.) | | | |
|---|---|---|---|---|---|---|---|
| | | SF | PF | 0.5 | 20 | 100 | 200 |
| Inventitive samples | No. 1 | 1.0 | 1.0 | 2.47 | 8.40 | 8.30 | 8.20 |
| | No. 2 | 1.0 | 1.5 | 5.46 | 5.91 | 5.20 | 5.69 |
| | No. 3 | 1.0 | 2.0 | 7.49 | 2.89 | 4.78 | 2.20 |
| | No. 4 | 1.0 | 3.0 | 10.14 | 1.91 | 1.41 | 2.00 |
| | No. 5 | 1.0 | 0 | 1.0 | 1.0 | 1.0 | 1.0 |

From the above table, the flexural toughness of the samples of the invention is found to show the following tendencies: (1) It increases with an increase of the PF amount and the sample No. 4 having a PF content of 3.0 vol% has a toughness of about 10 times as great as that of the SF-reinforced concrete (No. 5) at a loading speed of 0.5 mm/min; and that in all the samples, the greatest toughness is obtained at a loading speed of 0.5 mm/min and the toughness values are almost held constant at loading speeds ranging 20—200 mm/min in each sample.

These tendencies show that the characteristic of the PF serving also as a viscoelastic material gives some influence on the toughness. Anyway, it is clear that the reinforced concretes according to the invention show such an excellent toughness as not attained by the SF-reinforced concrete.

**Claims**

1. A fibre-reinforced concrete comprising a concrete matrix containing 1—6% by volume of a mixture of a short steel fibre (A) with a length of 20—60 mm and a thickness of 0.2—1 mm having a Young's modulus higher than that of the concrete and short polyethylene fibre (B) with a length of 5—100 mm and a thickness of 1000—15000 denier having a Young's modulus lower than the concrete and being an elongated extruded fibre of a cross section having projections distributed on the surface of the fibres at a frequency of 5 to 25 per 10 cm length with a height of 0.1 mm or more and diameter of 0.5—2 mm so that it has good adhesiveness to the concrete, the both fibres having been dispersed in said concrete matrix in a mixing volume ratio B/A ranging from 0.5 to 6 and the reinforcing amount of the short steel fibre (A) ranging from 0.5 to 3% by volume and that of the polyethylene fibre (B) ranging from 0.5 to 5% by volume.

2. The fibre-reinforced concrete composite as defined by Claim 1, the amount of the short fibres (A) ranging from 1 to 2% by volume, and the amount of the short fibres (B) ranging from 1 to 4% by volume.

3. The fibre-reinforced concrete composite as defined by Claim 1 or 2, said steel fibres having a Young's modulus ranging from 19,000 to 21,000 mg/mm$^2$ (186—206 GPa), being 0.2 to 1 mm in thickness and 20 to 60 mm in length.

4. The fibre-reinforced concrete composite as defined by Claim 1, 2, or 3, said fibres (B) having a Young's modulus ranging from 100 to 1,000 kg/mm$^2$ (980—9800 MPa).

5. The fibre-reinforced concrete composite as defined by Claim 4, said polyethylene fibres being longitudinally oriented and having a Young's modulus of about 500 kg/mm$^2$ (4900 MPa).

6. The fibre-reinforced concrete composite as defined by any preceding Claim, said polyethylene fibres being a mixture of a high density polyethylene with a melt index of 0.01—1.0 and 10—80 wt% of a high density polyethylene with a melt index below 0.01.

7. The fibre-reinforced concrete composite as defined by any preceding Claim, said mixing volume ratio B/A ranging from 1 to 3.

8. A crack-resistant, high tensile strength shaped article comprising the fibre-reinforced concrete composite as defined by any preceding Claim.

## Patentansprüche

1. Faserverstärkter Beton mit einer Betonmatrix, enthaltend 1 bis 6 Vol.-% eines Gemisches aus einer kurzen Stahlfaser (A) mit einer Länge von 20 bis 60 mm und einer Dicke von 0,2 bis 1 mm, die einen höheren Young'schen Modulus als derjenige von Beton aufweist, und einer kurzen Polyethylenfaser (B) mit einer Länge von 5 bis 100 mm und einer Dicke von 1000 bis 1500 Denier mit einem niedrigeren Young'schen Modulus als derjenige von Beton, die eine gelängte extrudierte Faser eines Querschnittes mit Vorsprüngen, verteilt auf der Oberflävche der Fasern in einer Frequenz von 5 bis 25 pro 10 cm Länge mit einer Höhe von 0,1 mm oder mehr und einem Durchmesser von 0,5 bis 2 mm, so daß sie an Beton gut haftet, ist, wobei beideFasern in der Betonmatrix in einem Mischungsvolumenverhältnis B/A im Bereich von 0,5 bis 6 dispergiert sind und die verstärkende Menge der kurzen Stahlfaser (A) im Bereich von 0,5 bis 3 Vol.% und diejenige der Polyethylenfaser (B) im Bereich von 0,5 bis 5 Vol.-% liegen.

2. Faserverstärkter Beton-Verbundstoff nach Anspruch 1, wobei die Menge der kurzen Fasern (A) von 1 bis 2 Vol. % und die Menge der kurzen Fasern (B) von 1 bis 4 Vol.-% reichen.

3. Faserverstärkter Beton-Verbundstoff nach Anspruch 1 oder 2, wobei die Stahlfasern einen Young'schen Modulus im Bereich von 19000 bis 21000 kg/mm$^2$ (186 bis 206 GPa) haben und 0,2 bis 1 mm dick und 20 bis 60 mm lang sind.

4. Faserverstärkter Beton-Verbundstoff nach Anspruch 1, 2 oder 3, wobei die Fasern (B) einen Young'schen Modulus im Bereich von 100 bis 1000 kg/mm$^2$ (980 bis 9800 MPa) haben.

5. Faserverstärkter Beton-Verbundstoff nach Anspruch 4, wobei die Polyethylenfasern in Längsrichtung orientiert sind und einen Young'schen Modulus von etwa 500 kh/mm$^2$ (49000 MPa) haben.

6. Faserverstärkter Beton-Verbundstoff nach einem der vorstehenden Ansprüche, wobei die Polyethylenfasern ein Gemisch aus einem Polyethylen hoher Dichte mit einem Schmelzindex von 0,01 bis 1,0 und 10 bis 80 Gew.-% aus einem Polyethylen hoher Dichte mit einem Schmelzindex unter 0,01 sind.

7. Faserverstärkter Beton-Verbundstoff nach einem der vorstehenden Ansprüche, wobei das Volumenverhältnis der Mischung B/A im Bereich von 1 bis 3 liegt.

8. Reißfester Formkörper hoher Zugfestigkeit, der den faserverstärkten Beton-Verbundstoff nach einem der vorstehenden Ansprüche enthält.

## Revendications

1. Béton renforcé de fibre comprenant une matrice de béton contenant 1 à 6 % en volume d'un mélange d'une fibre d'acier courte (A) ayant une longueur de 20 à 60 mm, une épaisseur de 0,2 à 1 mm et un module d'élasticité supérieur à celui du béton, et d'une fibre de polyéthylène courte (B) ayant une longueur de 5 à 100 mm, une épaisseur de 1000 à 15000 deniers et un module d'élasticité inférieur à celui du béton et étant constituée par une fibre extrudée allongée dont la section présente des saillies réparties à la surface des fibres, à raison de 5 à 25 pour 10 cm, leur hauteur de 0,1 mm ou plus et leur diamètre de 0,5 à 2 mm, de sorte qu'elle présente une bonne adhérence au béton, les deux fibres ayant été dispersées dans ladite matrice de béton selon un rapport de mélange en volume (B/A) compris entre 0,5 et 6, la quantité de fibre d'acier courte (A) allant de 0,5 à 3% en volume et celle de la fibre de polyéthylène (B) de 0,5 à 5%.

2. Béton composite renforcé de fibre selon la revendication 1, dans lequel la quantité de fibres courtes (A) va de 1 à 2 % en volume et la quantité de fibres courtes (B) de 1 à 4 %.

3. Béton composite renforcé de fibre selon la revendication 1 ou 2, dans lequel lesdites fibres d'acier ont un module d'élasticité allant de 19000 à 21000 kg/mm$^2$ (186 à 206 GPa), une épaisseur de 0,2 à 1 mm et une longueur de 20 à 60 mm.

4. Béton composite renforcé de fibre selon l'une des revendications 1 à 3, dans lequel lesdites fibres (B) ont un module d'élasticité allant de 100 à 1000 kg/mm$^2$ (980 à 9 800 MPa).

5. Béton composite renforcé de fibre selon la revendication 4, dans lequel lesdites fibres de polyéthylène sont orientées longitudinalement et ont un module d'élasticité d'environ 500 kg/mm$^2$ (4900 MPa).

6. Béton composite renforcé de fibre selon l'une des revendications précédentes, dans lequel lesdites fibres de polyéthylène sont un mélange d'un polyéthylène à haute densité dont l'indice de fusion est compris entre 0,01 et 1 et d'un polyéthylène à haute densité, représentant 10 à 80 % du poids, dont l'indice de fusion est inférieur à 0,01.

7. Béton composite renforcé de fibre selon l'une des revendications précédentes, dans lequel ledit rapport de mélange en volume (B/A) va de 1 à 3.

8. Objet résistant au fendillement et hautement résistent à la traction, comprenant le béton composite renforcé de fibre selon l'une des revendications précédentes.

FIG. 1

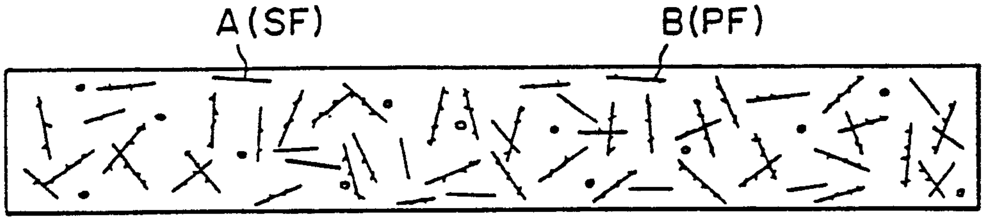


FIG. 2a

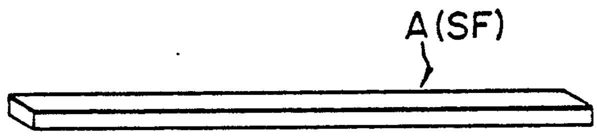


FIG. 2b

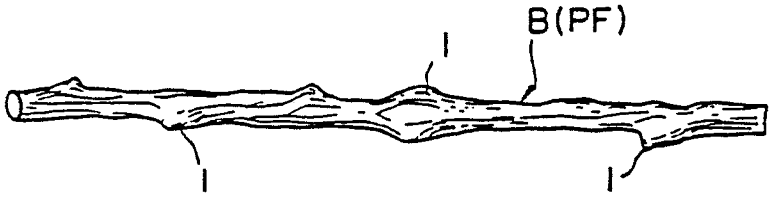

FIG. 3

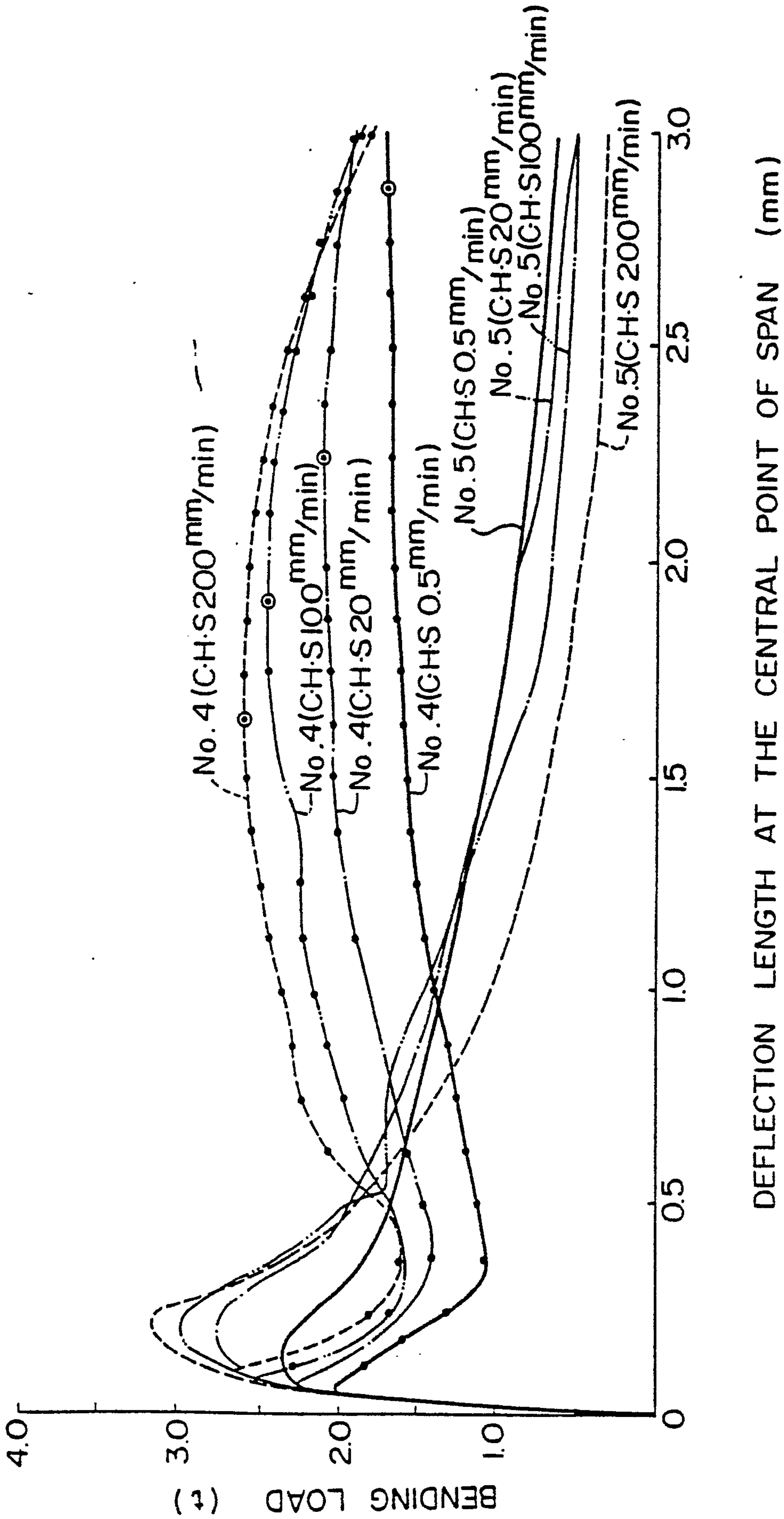

No. 4 (C·H·S 200 mm/min)
No. 4 (C·H·S 100 mm/min)
No. 4 (C·H·S 20 mm/min)
No. 4 (C·H·S 0.5 mm/min)
No. 5 (C·H·S 0.5 mm/min)
No. 5 (C·H·S 20 mm/min)
No. 5 (C·H·S 100 mm/min)
No. 5 (C·H·S 200 mm/min)
BENDING LOAD (t)
4.0
3.0
2.0
1.0
0
0.5
1.0
1.5
2.0
2.5
3.0
DEFLECTION LENGTH AT THE CENTRAL POINT OF SPAN (mm)

FIG. 4

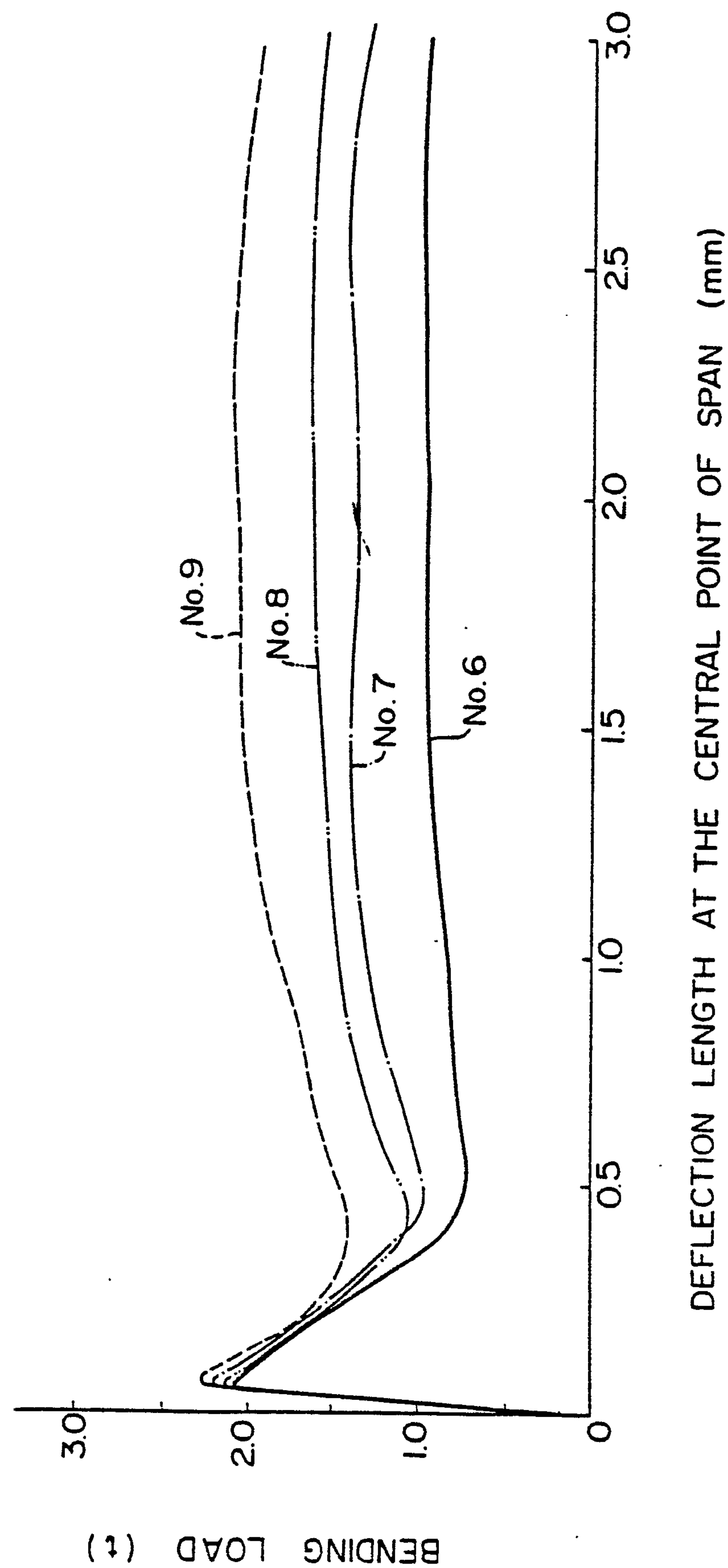

No.9
No.8
No.7
No.6
0
0.5
1.0
1.5
2.0
2.5
3.0
DEFLECTION LENGTH AT THE CENTRAL POINT OF SPAN (mm)
1.0
2.0
3.0
BENDING LOAD (t)

FIG.5

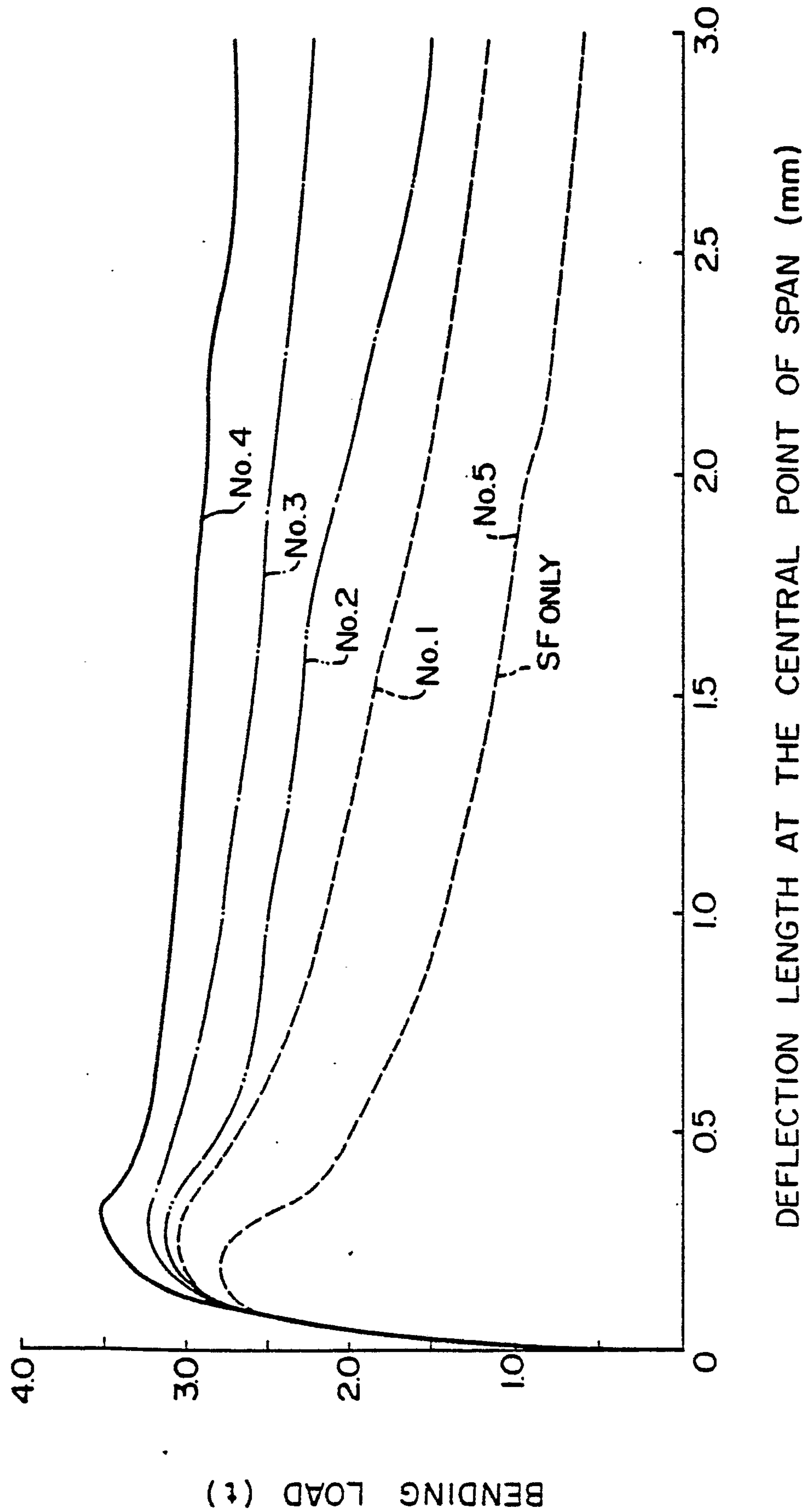
No.4
No.3
No.2
No.1
No.5
SF ONLY
0
0.5
1.0
1.5
2.0
2.5
3.0
DEFLECTION LENGTH AT THE CENTRAL POINT OF SPAN (mm)
1.0
2.0
3.0
4.0
BENDING LOAD (t)

FIG. 6

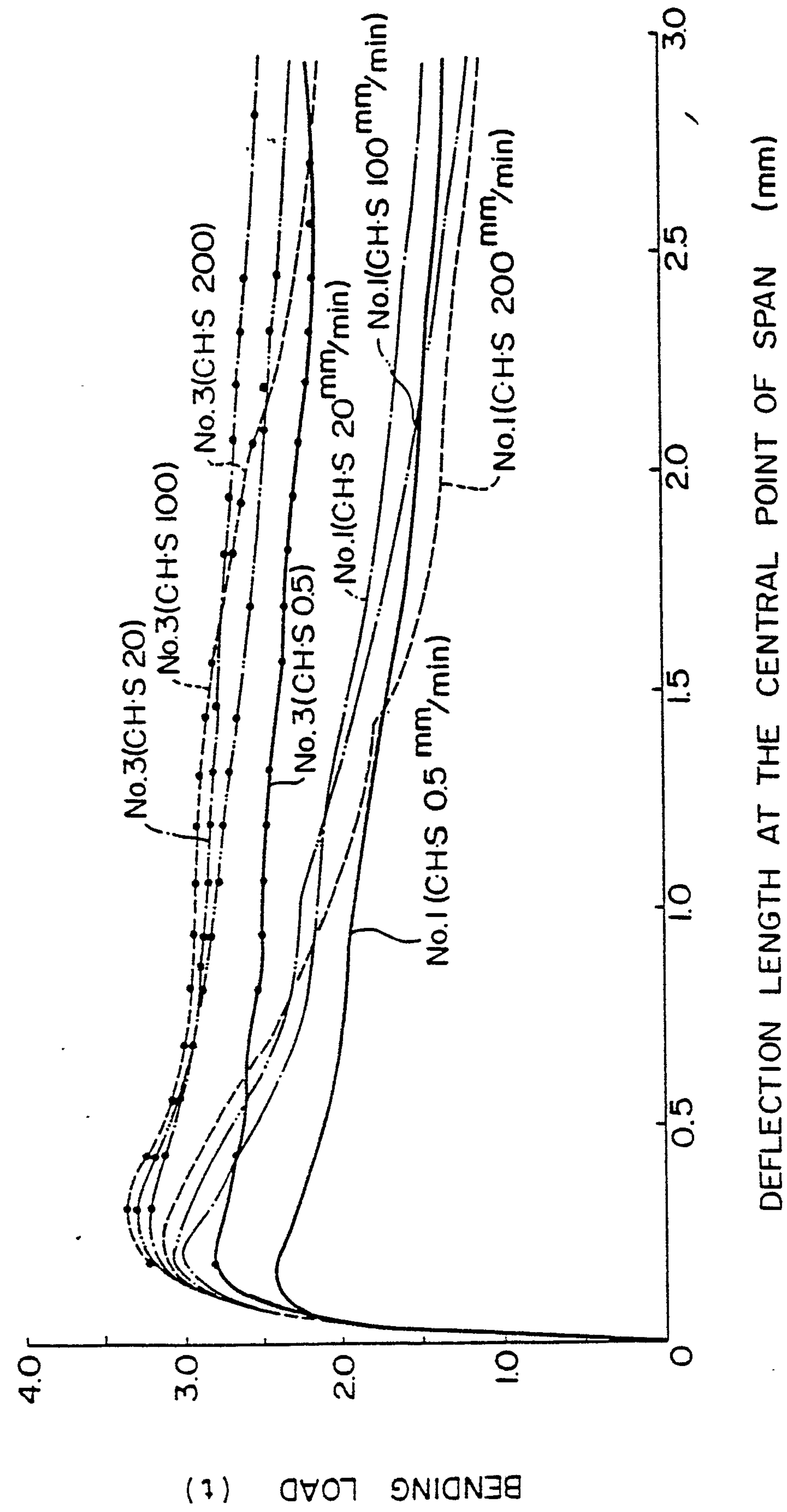

No.3(CH·S 20)
No.3(CH·S 100)
No.3(CH·S 200)
No.3(CH·S 0.5)
No.1(CH·S 20 mm/min)
No.1(CH·S 100 mm/min)
No.1(CH·S 200 mm/min)
No.1(CH·S 0.5 mm/min)
4.0
3.0
2.0
1.0
0
0.5
1.0
1.5
2.0
2.5
3.0
BENDING LOAD (t)
DEFLECTION LENGTH AT THE CENTRAL POINT OF SPAN (mm)

FIG. 7

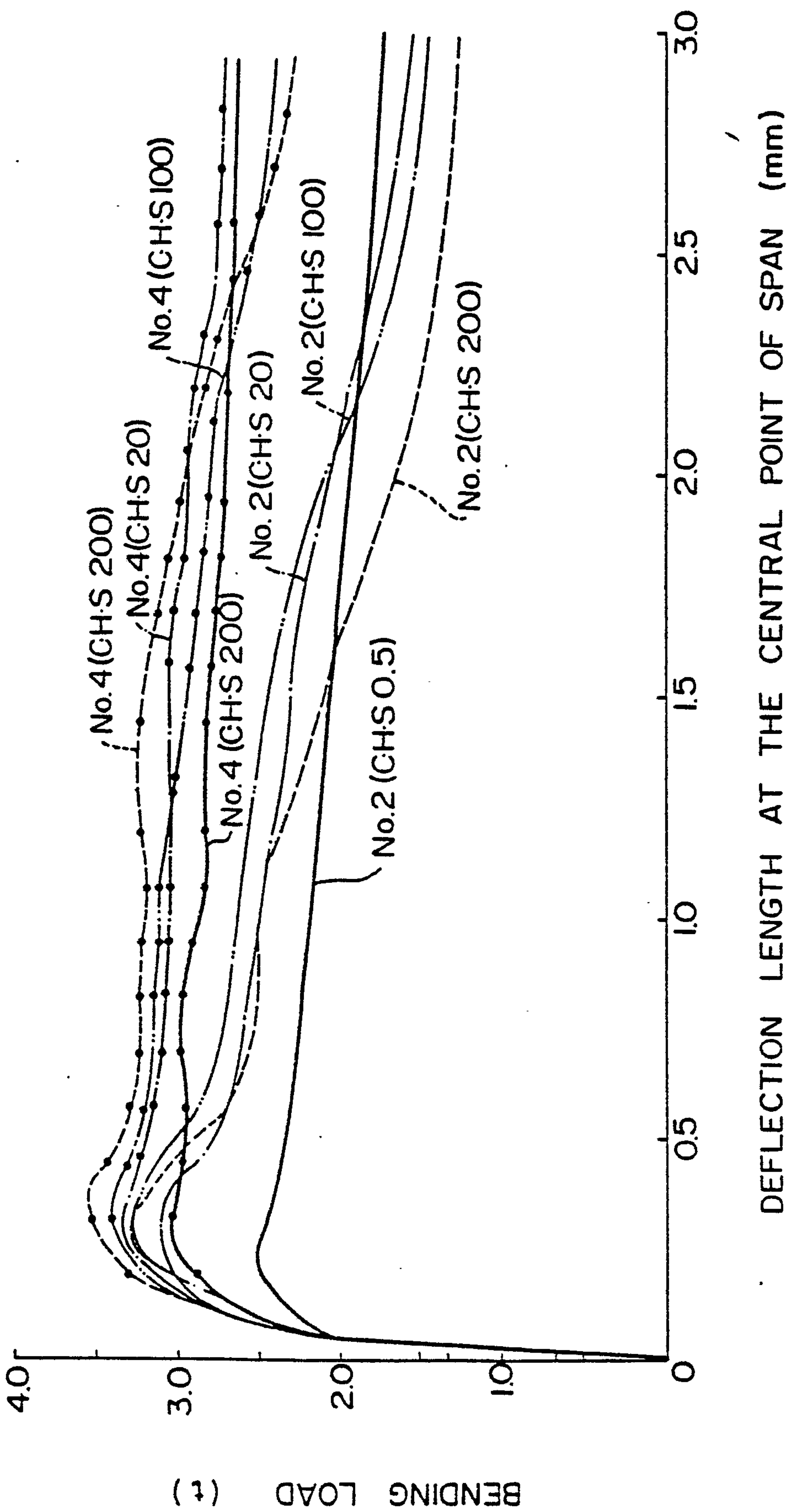
No.4(CH·S 200)
No.4(CH·S 20)
No.4(CH·S100)
No.4(CH·S 200)
No.2(CH·S 20)
No.2(CH·S 100)
No.2(CH·S 200)
No.2(CH·S 0.5)
No.2
4.0
3.0
2.0
1.0
0
0.5
1.0
1.5
2.0
2.5
3.0
DEFLECTION LENGTH AT THE CENTRAL POINT OF SPAN (mm)
BENDING LOAD (t)

FIG. 8

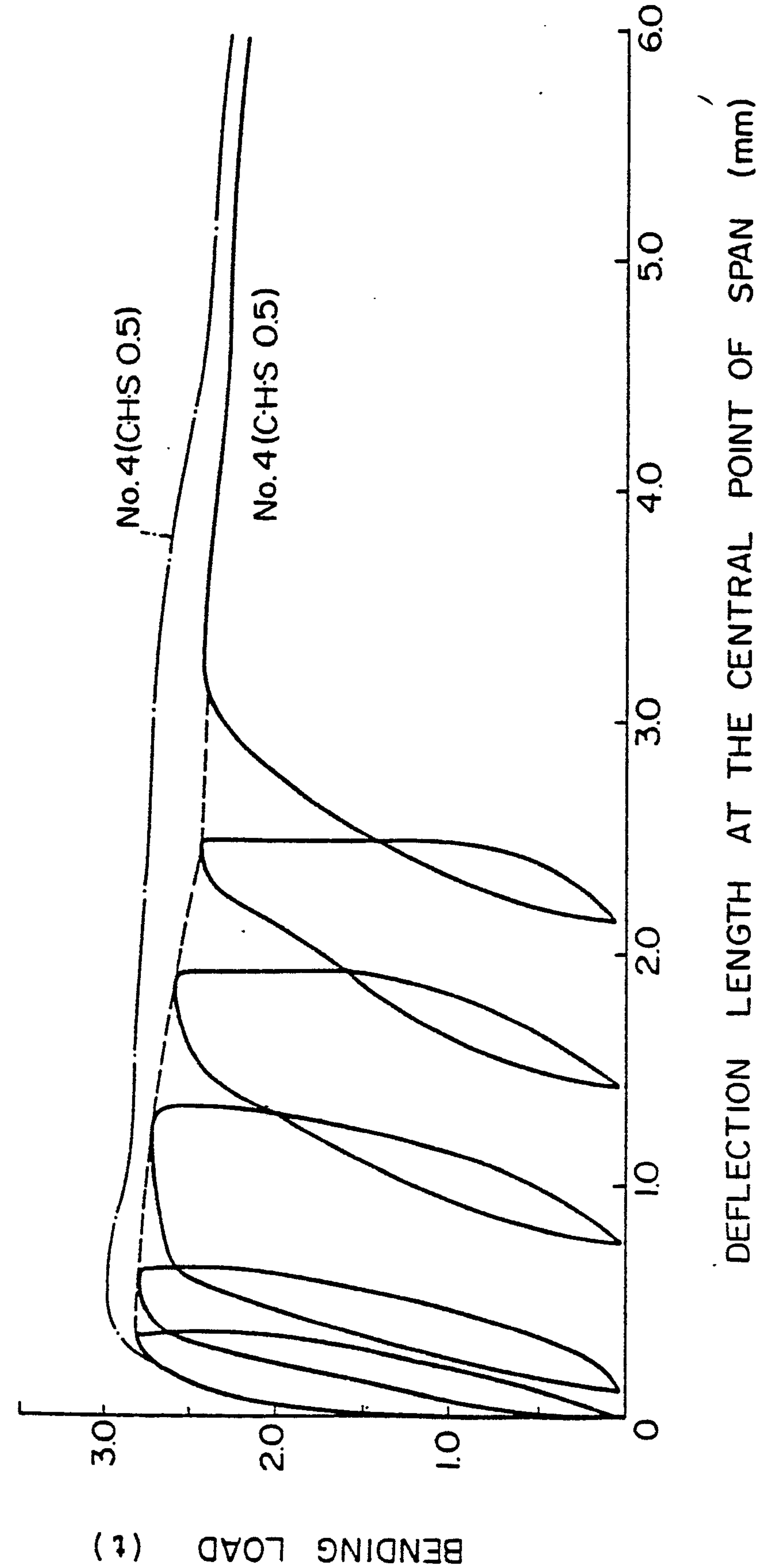

No.4(CH·S 0.5)
No.4(CH·S 0.5)
0
1.0
2.0
3.0
4.0
5.0
6.0
DEFLECTION LENGTH AT THE CENTRAL POINT OF SPAN (mm)
BENDING LOAD (t)